(19) Europäisches Patentamt / European Patent Office / Office européen des brevets

(11) **EP 4 723 482 A1**

(12) **DEMANDE DE BREVET EUROPEEN**

(43) Date de publication:
08.04.2026 Bulletin 2026/15

(21) Numéro de dépôt: 24306636.2

(22) Date de dépôt: 04.10.2024

(51) Classification Internationale des Brevets (IPC):
**H03L 7/087** (2006.01)  **H03L 7/081** (2006.01)
**H03L 7/10** (2006.01)

(52) Classification Coopérative des Brevets (CPC):
**H03L 7/0812; H03L 7/081; H03L 7/087; H03L 7/101**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(71) Demandeur: **Magajna, Patrick**
**78730 Ponthevrard (FR)**

(72) Inventeur: **MAGAJNA, Patrick**
**78730 PONTHEVRARD (FR)**

(74) Mandataire: **IPAZ**
**Bâtiment Platon**
**Parc Les Algorithmes**
**91190 Saint-Aubin (FR)**

Remarques:
Revendications modifiées conformément à la règle 137(2) CBE.

(54) **SYSTÈME DE CORRECTION DE BRUIT DE PHASE D'UNE BOUCLE À VERROUILLAGE DE PHASE ET PROCÉDÉ ASSOCIÉ**

(57) L'invention porte sur un système de correction du bruit de phase d'une boucle à verrouillage de phase (PLL). Son mode de fonctionnement repose sur l'augmentation de la récurrence des corrections de l'erreur de phase entre un signal de sortie de la boucle à verrouillage de phase (PLL) et un signal de référence ($S_R$), de fréquence multiple d'une fréquence de comparaison de la boucle à verrouillage de phase (PLL).

La diminution de l'intervalle de temps entre deux impulsions de correction permet de limiter la diffusion de la phase de l'oscillateur variable commandé en tension (4), phénomène qui est intrinsèque à son fonctionnement en mode autonome, ce qui permet d'améliorer le bruit de phase du signal en sortie de la boucle à verrouillage de phase (PLL), ceci sur une bande passante pouvant être définie indépendamment de celle de la boucle à verrouillage de phase (PLL).

[Fig. 1]

EP 4 723 482 A1

## Description

### Domaine technique

La présente invention concerne un système de correction de bruit de phase d'une boucle à verrouillage de phase.

L'invention concerne également un procédé associé.

L'invention s'applique au domaine des boucles à verrouillage de phase, utilisées notamment dans des circuits électroniques à des fins de synthèse de fréquence ou pour la récupération d'horloge, dans des domaines tels que les radiofréquences, les hyperfréquences ou les systèmes numériques.

### État de la technique

Il est bien connu de l'état de l'art d'utiliser des systèmes configurés pour générer un signal dont la fréquence peut être ajustée par pas prédéfinis au moyen d'un synthétiseur de fréquence à pas entier. Ces systèmes sont généralement mis en oeuvre dans une boucle à verrouillage de phase qui comprend au moins un oscillateur commandé en tension, un diviseur de fréquence, un filtre de boucle, un comparateur de phase/fréquence recevant sur une entrée un signal de comparaison généré à partir d'un oscillateur de référence et sur une deuxième entrée, le signal issu du diviseur de fréquence. Les impulsions, générées par le comparateur de phase/-fréquence, permettent d'ajuster la tension de l'oscillateur commandé en tension afin de verrouiller sa phase sur celle du signal de comparaison.

Cependant, ces systèmes de synthèse à pas entier présentent certaines limitations :

- Le bruit de phase de l'oscillateur commandé en tension ne peut être corrigé par la boucle à verrouillage de phase que dans sa bande passante $f_{PLL}$. Or celle-ci est contrainte par la fréquence de comparaison $f_c$, une règle de dimensionnement approximative correspondant à

$$f_{PLL} = \frac{f_c}{10}\ [1].$$

- Lorsque la résolution en fréquence du signal synthétisé est faible, le rang de division N devient important. Or le niveau de bruit de phase du signal de sortie, dans la bande passante de la boucle à verrouillage de phase est principalement défini par celui du signal à la fréquence de comparaison, augmenté d'un terme égal à 20 * $log(N)$.

Pour surmonter ces limitations, certaines solutions connues consistent à utiliser un diviseur de fréquence à pas fractionnaire. Le diviseur de fréquence à pas fractionnaire permet de générer un signal avec une fréquence ayant une résolution correspondant à un pas fractionnaire de la fréquence de comparaison.

Cela permet :

- d'obtenir une bande passante $f_{PLL}$ plus large et donc une correction du bruit de phase sur une bande plus étendue,

- de diminuer la valeur du rang de division N et par conséquent le niveau de bruit de phase dans cette bande de fréquence.

Différentes méthodes ont été envisagées afin d'obtenir un pas fractionnaire, la plus utilisée actuellement étant le diviseur à modulateur sigma-delta $\Sigma$ - $\Delta$. Cependant cette méthode introduit d'autres inconvénients :

- Elle introduit un bruit de quantification qui dégrade les performances en bruit du système bouclé [2] ;
- Pour pallier ce problème, une approche consiste à augmenter l'ordre du modulateur sigma-delta afin d'améliorer la rejection du bruit de quantification présent proche de la porteuse, avec la contrepartie d'augmenter ce bruit loin de celle-ci. Cependant, si l'on veut filtrer ce surcroît de bruit par l'intermédiaire de la boucle à verrouillage de phase, dont la réponse correspond à un filtre passe-bas, il est nécessaire d'avoir une boucle à verrouillage de phase d'un ordre supérieur à celui du modulateur, ce qui implique pour des raisons de stabilité de diminuer la bande passante du filtre de boucle et va donc à l'encontre du but recherché en adoptant une architecture sigma-delta. Un compromis est alors nécessaire [3] ;

- Même si cette méthode repose sur le déplacement du bruit de quantification vers des fréquences loin de la porteuse, des limitations apparaissent, notamment un phénomène de repliement de spectre du bruit de quantification des fréquences hautes vers les fréquences plus basses, ainsi que l'introduction de raies parasites sur le spectre de sortie. Ces phénomènes sont dus, entre autres, aux variations du retard introduit par le diviseur de fréquence en fonction du rang de division, ainsi qu'aux non-linéarités de la caractéristique du comparateur de phase/fréquence [4], [1] ;
- De plus cette méthode induit une augmentation de la consommation liée aux circuits permettant le calcul numérique nécessaires à son implémentation.

Par conséquent, la méthode proposée introduit un bruit et des raies parasites supplémentaires ainsi qu'une augmentation de la consommation.

On peut remarquer que dans ces systèmes, à chaque front de la fréquence de comparaison $f_c$, une impulsion correspondant à l'erreur de phase est produite ce qui permet de recaler la phase de l'oscillateur commandé en tension. Or, entre deux impulsions la boucle est ouverte et l'oscillateur commandé en tension, qui est alors dans un mode de fonctionnement autonome, subit un phénomène de diffusion de sa phase dans le temps [5]. Ainsi, plus l'écart temporel entre deux corrections de la phase de l'oscillateur commandé en tension est important, plus le bruit de phase s'approchera de celui intrinsèque à l'oscillateur commandé en tension.

De plus, cette correction du bruit de phase intrinsèque à l'oscillateur commandé en tension par la boucle à verrouillage de phase ne s'opère que dans la bande passante de celle-ci. Ces systèmes ne permettent pas de corriger le bruit de phase de l'oscillateur commandé en tension sur une bande de fréquence arbitraire.

Un but de la présente invention est de remédier à au moins un des inconvénients de l'état de la technique décrit ci-dessus.

Un autre but de l'invention est de permettre de corriger le bruit de phase sur une bande de fréquence dont la largeur est définie indépendamment d'une bande passante de la boucle à verrouillage de phase.

Un autre but de l'invention est de diminuer le niveau de bruit de phase présent en sortie de la boucle à verrouillage de phase dans une bande de fréquence définie par un système de correction de bruit de phase.

Un autre but de l'invention est de proposer un système de correction de bruit de phase totalement intégrable.

**Exposé de l'invention**

À cet effet, l'invention concerne un système de correction de bruit de phase d'une boucle à verrouillage de phase, la boucle à verrouillage de phase comprenant un signal de référence, le système de correction de bruit de phase comprenant au moins :

- un compteur générateur de trame recevant en entrée un signal de sortie de la boucle à verrouillage de phase et étant configuré pour générer, en sortie, au moins un signal de détection de bruit défini sous la forme d'une trame, la trame étant composée de plusieurs blocs définis temporellement, chaque bloc définissant un front actif ;

- une unité de déphasage configurée pour générer au moins un signal de détection de bruit retardé, chaque signal de détection de bruit retardé comprenant un retard distinct, l'unité de déphasage étant configurée pour synchroniser au moins un front actif de l'au moins un signal de détection de bruit retardé avec au moins un front actif du signal de référence, chaque retard distinct étant défini de façon à ce qu'une moyenne des écarts instantanés entre un front actif de l'au moins un signal de détection de bruit retardé et un front actif du signal de référence converge vers zéro ;

- une unité de détection corrective configurée pour :

  • calculer une erreur de phase instantanée sur la base d'une comparaison entre un front actif de l'au moins un signal de détection de bruit retardé et un front actif du signal de référence ;

  • générer des impulsions en fonction de l'erreur de phase instantanée de façon à corriger un bruit de phase de la boucle à verrouillage de phase.

En effet, l'invention consiste à associer un système de correction de bruit de phase sous la forme d'une boucle à une boucle à verrouillage de phase, ou « Phase-Locked Loop », afin de générer des impulsions permettant la correction du bruit de phase de ladite boucle à verrouillage de phase avec une période de récurrence inférieure à la période de comparaison. En diminuant l'intervalle de temps entre deux impulsions de correction du bruit de phase, on limite la diffusion de la phase de l'oscillateur variable commandé en tension qui est intrinsèque à son fonctionnement en mode autonome.

Plus particulièrement, par l'adjonction d'une seconde boucle opérant à une fréquence de référence supérieure à la fréquence de comparaison de la boucle à verrouillage de phase, le bruit de phase du signal en sortie de ladite boucle à verrouillage de phase est amélioré, sur une bande passante qui peut être définie indépendamment de la bande passante de la boucle à verrouillage de phase, par ailleurs contrainte par des exigences sur la stabilité et sur le comportement dynamique de la boucle à verrouillage de phase.

Le système selon l'invention permet l'augmentation de la récurrence des corrections de l'erreur de phase entre le signal de sortie de la boucle à verrouillage de phase et le signal de référence, de fréquence multiple de la fréquence de comparaison de la boucle à verrouillage de phase.

On entend par « front actif », un front montant ou un front descendant. De préférence, le front actif est un front montant.

De façon avantageuse, le système selon l'invention présente une ou plusieurs des caractéristiques suivantes, prises isolément ou selon toute combinaison techniquement possible :

- le système peut comprendre, en outre, un filtre de boucle de correction de bruit, le filtre de boucle de correction de bruit étant connecté à une sortie de l'unité de détection corrective ;

- la boucle à verrouillage de phase peut comprendre au moins un oscillateur variable commandé en tension, la correction de bruit de phase pouvant être appliquée à au moins une entrée de l'oscillateur commandé en tension ;

- la boucle à verrouillage de phase peut comprendre au moins une cellule à retard variable, la correction de bruit de phase pouvant être appliquée sur une entrée de contrôle de l'au moins une cellule à retard variable ;

- le système peut comprendre, en outre, une boucle de retard initiale, recevant en entrée, l'au moins un signal de détection de bruit généré par le compteur générateur de trame et pouvant être configurée pour générer en sortie, pour chaque signal de détection de bruit, au moins un signal de détection de bruit différé de façon qu'au moins un front actif du signal de détection de bruit différé soit synchronisé avec au moins un front actif du signal de référence ;

- l'unité de déphasage peut comprendre au moins une chaine de déphasage variable et une cellule de déphasage final variable ;

- l'au moins une chaine de déphasage variable peut comprendre des cellules élémentaires à retard variable placées en série, les cellules élémentaires à retard variable ayant un déphasage $\Phi_{vare}$ identique ;

- la longueur de la trame du signal de détection de bruit retardé peut être inférieure ou égale à un multiple entier d'une période d'un signal de comparaison ;

- l'unité de détection corrective peut être configurée pour comparer un front actif du signal de référence sur deux avec un front actif de l'au moins un signal de détection de bruit retardé.

Selon un autre aspect de l'invention, il est proposé un procédé de correction de bruit de phase d'une boucle à verrouillage de phase, la boucle à verrouillage de phase comprenant un signal de référence, le procédé étant mis en oeuvre par ordinateur et comprenant les étapes suivantes :

- générer au moins un signal de détection de bruit défini sous la forme d'une trame à partir d'un signal de sortie de la boucle à verrouillage de phase, la trame étant composée de plusieurs blocs définis temporellement, chaque bloc définissant un front actif ;

- générer au moins un signal de détection de bruit retardé, chaque signal de détection de bruit retardé comprenant un retard distinct,

- synchroniser au moins un front actif de l'au moins un signal de détection de bruit retardé avec au moins un front actif du signal de référence, chaque retard distinct étant défini de façon qu'une moyenne des écarts instantanés entre un front actif de l'au moins un signal de détection de bruit retardé et un front actif du signal de référence converge vers zéro ;

- calculer une erreur de phase instantanée sur la base d'une comparaison entre un front actif de l'au moins un signal de détection de bruit retardé et un front actif du signal de référence ;

- générer des impulsions en fonction de l'erreur de phase instantanée de façon à corriger un bruit de phase de la boucle à verrouillage de phase.

**Brève description des figures**

L'invention sera mieux comprise à la lecture de la description qui va suivre, donnée uniquement à titre d'exemple non limitatif et faite en se référant aux dessins annexés sur lesquels :

- la figure 1 représente un système électronique selon un premier mode de réalisation de l'invention ;

- la figure 2 représente une construction d'une trame d'un signal de détection de bruit selon un mode de réalisation de l'invention ;

- les figures 3a) à 3g) représentent un signal de référence, un signal d'erreur et un déphasage des trames des signaux de détection de bruit selon un mode de réalisation de l'invention ;

- la figure 4 représente un système électronique selon un second mode de réalisation de l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si c'est cette partie qui est uniquement suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures et dans la suite de la description, les éléments communs à plusieurs figures conservent la même référence.

## Description détaillée

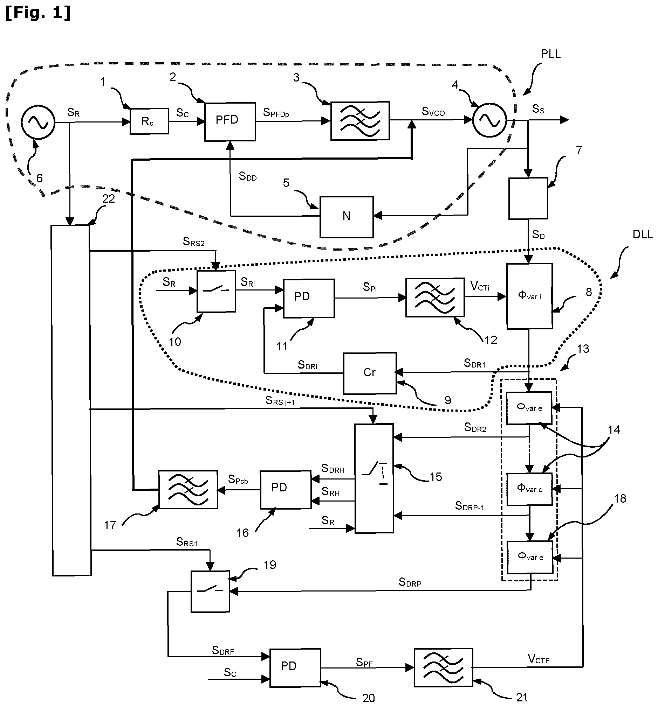

La figure 1 représente un système électronique selon un premier mode de réalisation. Le système électronique comprend :

- une boucle à verrouillage de phase PLL ;

- un circuit de génération de signaux de sélection 22 ;

- un système de correction de bruit comprenant une boucle de retard DLL.

La boucle à verrouillage de phase PLL comprend un compteur 1, un comparateur de phase/fréquence 2, un filtre 3, un oscillateur variable commandé en tension 4, un diviseur 5 et un oscillateur de référence 6.
Un signal de référence $S_R$ est généré par l'oscillateur de référence 6. Celui-ci a une période $T_R$ , de fréquence $F_R$. Le signal de référence $S_R$ est envoyé au compteur 1 générant en sortie un signal de comparaison $S_c$. Le compteur 1 a pour horloge le signal de référence $S_R$ et pour rang de division la valeur

$$R_c = P \in \mathbb{N}.$$

Le comparateur de phase/fréquence 2 reçoit en entrée le signal de comparaison $S_c$ ainsi que le signal $S_{DD}$, issu du diviseur de fréquence par N 5.
Le comparateur de phase/fréquence 2 compare les deux signaux et génère en sortie un signal $S_{PFDp}$ correspondant à un signal de différence de phase. Ce signal de différence de phase comprend des impulsions par période de comparaison $T_C$, de largeur $T_{er}$, lorsque la boucle à verrouillage de phase PLL est verrouillée. Ce signal $S_{PFDp}$ est envoyé sur l'entrée d'un filtre 3, qui génère en sortie un signal filtré permettant d'ajuster la valeur d'une grandeur de contrôle de l'oscillateur variable commandé en tension 4. En sortie, l'oscillateur variable commandé en tension 4 génère le signal $S_s$ de période $T_s$. Le signal $S_s$ correspond au signal de sortie de la boucle à verrouillage de phase PLL.
La période de comparaison $T_c$ est obtenue à partir de P coups d'horloge de l'oscillateur de référence 6. Sur une période $T_c$, les fronts actifs du signal de comparaison $S_c$ sont dénommés $F_{cm}$ et les fronts actifs du signal de référence $S_R$ sont dénommés dans l'ordre d'apparition : $F_{Rmk}$, avec $1 \leq k \leq P$, $k \in \mathbb{N}$ . En sortie du compteur 1, les fronts actifs $F_{Rm1}$ du signal de référence $S_R$ coïncide avec les fronts actifs $F_{cm}$ du signal de comparaison $S_c$.
Le signal de sortie $S_s$ est envoyé sur un compteur générateur de trames 7. Le compteur générateur de trame appartient à la boucle de détection de bruit et génère, à partir de ce signal $S_s$, et pour chaque période de comparaison $T_c$, un signal de détection de bruit sous forme de trame de longueur temporelle $T_T$. La valeur du compteur générateur de trame 7, remise à zéro en début de chaque période de comparaison $T_c$, évolue pendant cette période pour atteindre la valeur finale :

$$N_D = B.P + A \text{ avec } A, B \in \mathbb{N}.$$

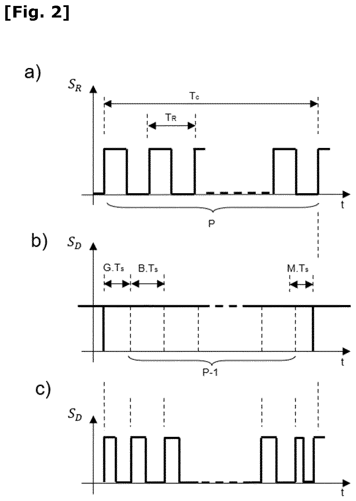

Les figures 2a) à 2c) décrivent le signal de référence et le signal de détection de bruit à différents stades de traitement. En effet, sur la figure 2a) est représenté un signal de référence en fonction du temps. On peut voir sur la figure 2b) que le signal de détection de bruit est organisé en P-1 blocs principaux contigus, chacun de longueur temporelle $T_B = B.T_s$ précédés par un bloc d'amorçage, de longueur temporelle $T_g = G.T_s$, avec $G \leq B$ et suivis d'un bloc de fin de longueur temporelle $T_M = M.T_s$, avec $M = B - G + A \geq 0$. Le signal de détection de bruit généré en sortie $S_D$ du compteur générateur de trames 7 est construit de sorte qu'un front actif est généré en début de chaque bloc, selon la figure 2c).
Les fronts actifs du signal $S_D$ sont dénommés dans l'ordre d'apparition

$$F_{Dmk}, \text{ avec } 1 \leq k \leq P+1, k \in \mathbb{N}.$$

Selon la figure 1, des signaux de sélection $S_{RSk}$, avec $1 \leq k \leq P$, $k \in \mathbb{N}$ sont créés à partir du signal de référence $S_R$, par le circuit de génération des signaux de sélection 22. Le signal de sélection $S_{RSk}$ est actif durant une impulsion dont le front montant se produit avant celui du signal de référence $F_{Rmk}$, tandis que son front descendant se produit après. La durée entre le front montant et le front descendant de cette impulsion est inférieure à la période de référence $T_R$.
Le système de correction de bruit comprend une boucle de retard DLL. Cette boucle de retard DLL comprend une cellule de déphasage initial variable 8, une cellule de criblage de blocs 9, une cellule de sélection initiale 10, un comparateur de phase 11 et un filtre de contrôle du déphasage initial 12. Dans d'autres modes de réalisation, la boucle de retard DLL n'est pas comprise dans le système de correction de bruit selon l'invention. L'invention ne se limite donc pas au mode de réalisation présenté.
Le signal de détection de bruit $S_D$, généré en sortie du compteur générateur de trame 7, est envoyé sur une cellule à retard variable dénommée cellule de déphasage initial variable 8, qui génère en sortie un signal $S_{DR1}$ correspondant au signal $S_D$ déphasé d'une valeur : $\Phi_{var\,i}$.
Le signal $S_{DR1}$ est envoyé à l'entrée de la cellule de criblage de blocs 9 qui génère en sortie le signal $S_{DRi}$. Le front actif du signal $S_{DRi}$ correspond au front actif $F_{Dm2}$ du signal $S_{DR1}$.
Le signal de référence $S_R$ est envoyé sur l'entrée de la cellule de sélection initiale 10, qui reproduit sur sa sortie $S_{Ri}$ le signal de référence $S_R$, pendant l'intervalle de temps où le signal $S_{RS2}$ est actif, c'est-à-dire autour du front $F_{Rm2}$ du signal de référence $S_R$.

Les signaux $S_{Ri}$ et $S_{DRi}$ sont envoyés respectivement sur l'entrée référence et sur l'entrée diviseur du comparateur de phase 11 de contrôle du déphasage initial. Celui-ci génère en sortie un signal $S_{Pi}$ correspondant à une impulsion dont un des fronts actifs correspond au front actif $F_{Dm2}$ du signal $S_{DR1}$ et l'autre au front actif $F_{Rm2}$.

Ce signal $S_{Pi}$ est envoyé sur l'entrée d'un filtre de contrôle du déphasage initial 12, qui génère en sortie le signal correspondant à la valeur d'une grandeur de contrôle $V_{CTi}$ de la cellule de déphasage initial variable 8. Avantageusement, la valeur de la largeur de l'impulsion du signal $S_{Pi}$, comptée positive ou négative en fonction de l'occurrence dans le temps des fronts actifs $F_{Dm2}$ du signal $S_{DR1}$ et $F_{Rm2}$, permet de corriger la valeur de $V_{CTi}$ afin d'obtenir, en régime permanent, la coïncidence temporelle des fronts actifs $F_{Dm2}$ du signal $S_{DR1}$ et $F_{Rm2}$.

Selon la figure 1, le système de correction de bruit comprend, en outre, le compteur générateur de trame 7 comme décrit ci-dessus, une unité de déphasage 13, une unité de sélection des signaux de correction 15, une unité de détection corrective 16, un filtre de boucle de correction du bruit 17, une cellule de sélection finale 19, un comparateur de phase 20 de l'unité de déphasage et un filtre 21 de l'unité de déphasage. Plus particulièrement, l'unité de déphasage 13 comprend une chaine de déphasage variable 14 et une cellule de déphasage final variable 18. Dans le mode de réalisation décrit, l'unité de détection corrective 16 est définie sous la forme d'un comparateur de phase.

L'unité de déphasage 13 est configurée pour générer au moins un signal de détection de bruit retardé. L'unité de déphasage 13 est également configurée pour synchroniser au moins un front actif de l'au moins un signal de détection de bruit retardé avec au moins un front actif du signal de référence $S_R$. Chaque signal de détection de bruit retardé comprend un retard distinct, chaque retard distinct étant défini de façon qu'une moyenne des écarts instantanés entre un front actif de l'au moins un signal de détection de bruit retardé et un front actif du signal de référence $S_R$ converge vers zéro.

En effet, le signal $S_{DR1}$ passe dans l'unité de déphasage 13, comprenant P-2 cellules élémentaires à retard distinct variable 14 placées en série, effectuant chacune un retard distinct d'une valeur $\Phi_{var\ e}$ entre le signal entrant $S_{DRk}$ et le signal sortant $S_{DRk+1}$ avec $1 \leq k \leq$ $P$-2, $k \in \mathbb{N}$. Le signal de sortie $S_{DRk+1}$ correspond à un signal de détection de bruit retardé.

Les signaux de détection de bruit retardés $S_{DRk+1}$ ainsi que le signal de référence $S_R$ sont envoyés sur les entrées de l'unité de sélection des signaux de correction 15, qui reproduit sur la sortie $S_{DRH}$ le signal de détection de bruit retardé $S_{DRk+1}$ et sur la sortie $S_{RH}$ le signal de référence $S_R$, pendant l'intervalle de temps où le signal $S_{RSk+2}$ est actif, c'est-à-dire autour du front $F_{RMk}$

$_{+2}$. Les signaux des sorties $S_{RH}$ et $S_{DRH}$ sont ensuite envoyés respectivement sur l'entrée référence et sur l'entrée diviseur de l'unité de détection corrective 16.

Avantageusement, l'unité de détection corrective 16 est configurée pour calculer une erreur de phase instantanée sur la base de la comparaison entre un front actif du signal de détection de bruit retardé $S_{DRk+1}$ et un front actif du signal de référence et pour générer des impulsions à partir de l'erreur de phase instantanée calculée.

L'unité de détection corrective 16 génère donc en sortie un signal $S_{Pcb}$ correspondant à une série de P-2 impulsions sur une période de comparaison. Un des fronts de l'impulsion n°k est commun au front $F_{Dmk+2}$ du signal $S_{DRk+1}$ et l'autre au front $F_{Rmk+2}$.

Le signal $S_{Pcb}$ est envoyé sur l'entrée du filtre de boucle de correction du bruit 17. Le signal de sortie est ensuite envoyé sur une entrée de l'oscillateur variable commandé en tension 4 (ou sortie du filtre 3), ce qui permet de modifier la valeur de la grandeur de contrôle de celui-ci et par conséquent, de corriger le bruit.

Dans un autre mode de réalisation, le signal $S_{Pcb}$ est envoyé directement sur une entrée du filtre 3 ce qui permet de modifier la valeur de la grandeur de contrôle de celui-ci et par conséquent, de corriger le bruit.

Comme décrit précédemment, le système de correction de bruit comprend, en outre, une cellule de déphasage final variable 18, une cellule de sélection finale 19, un comparateur de phase 20 de l'unité de déphasage et un filtre 21 de l'unité de déphasage.

En sortie de la chaine de déphasage variable est généré le signal $S_{DRP-1}$, qui est envoyé sur l'entrée de la cellule de déphasage final variable 18, qui génère en sortie un signal $S_{DRP}$ correspondant au signal $S_{DRP-1}$ déphasé d'une valeur : $\Phi_{var\ e}$. La grandeur de contrôle de cette cellule est identique à celle contrôlant les cellules élémentaires à retard distinct variable 14.

Le signal $S_{DRP}$ est ensuite envoyé sur l'entrée de la cellule de sélection finale 19, qui reproduit sur sa sortie $S_{DRF}$, le signal $S_{DRP}$ pendant l'intervalle de temps où le signal $S_{RS1}$ est actif, c'est-à-dire autour du front $F_{cm}$ du signal de comparaison $S_C$ de la période de comparaison suivante. Le signal de sortie de cette cellule est envoyé sur l'entrée diviseur du comparateur de phase 20.

Le signal de comparaison $S_C$ est envoyé sur l'entrée référence du comparateur de phase 20, qui génère en sortie un signal $S_{PF}$ correspondant à une impulsion dont un des fronts actifs correspond au front actif $F_{DmP+1}$ du signal $S_{DRP}$ et l'autre au front actif $F_{cm}$ de la période de comparaison suivante.

Le signal $S_{PF}$ est envoyé sur l'entrée du filtre 21 de l'unité de déphasage, qui génère en sortie le signal $V_{CTF}$, correspondant à la valeur de la grandeur de contrôle de l'unité de déphasage 13, plus particulièrement, de la chaine de déphasage variable ainsi que de la cellule de déphasage final variable 18.

Avantageusement, la valeur de la largeur de l'impulsion du signal $S_{PF}$, comptée positive ou négative en fonction de l'occurrence dans le temps des fronts actifs $F_{DmP+1}$ du signal $S_{DRP}$ et $F_{cm}$ de la période de comparaison suivante, permet de corriger la valeur de $V_{CTF}$, afin d'obtenir, en régime permanent, la synchronisation en moyenne des fronts actifs $F_{DmP+1}$ du signal $S_{DRP}$ et $F_{cm}$ de la période de comparaison suivante.

En exemple, la cellule de sélection 10 peut être décrite comme composée d'une porte 'ET' à deux entrées. Sur ces entrées sont envoyés respectivement le signal de référence $S_R$ et le signal $S_{RS2}$ sortant du circuit de génération des signaux de sélection 22. Cette porte génère en sortie un signal $S_{Ri}$ qui est envoyé sur l'entrée référence du comparateur de phase 11.

La cellule de sélection des signaux de correction 15 peut, par exemple, être décrite comme composée de deux circuits logiques A et B identiques, chacun formé de P-2 portes 'ET' à deux entrées, dénommées $ETH_{Ak}$ et $ETH_{Bk}$ avec $1 \leq k \leq P - 2$, $k \in \mathbb{N}$ et d'une porte 'OU' à P-2 entrées, dénommées $OUH_A$ et $OUH_B$.

Dans le circuit A, sur chacune des entrées de la porte $ETH_{Ak}$ est envoyé respectivement le signal $S_{DRk+1}$ et le signal $S_{RSk+2}$. La sortie de chacune des portes $ETH_{Ak}$ est connectée à une entrée différente de la porte $OUH_A$. Celle-ci génère en sortie un signal $S_{DRH}$ qui est envoyé sur l'entrée diviseur de l'unité de détection 16.

Dans le circuit B sur chacune des entrées de la porte $ETH_{Bk}$ est envoyé respectivement le signal de référence $S_R$ et le signal $S_{RSk+2}$. La sortie de chacune des portes $ETH_{Bk}$ est connectée à une entrée différente de la porte $OUH_B$. Celle-ci génère en sortie un signal $S_{RH}$ qui est envoyé sur l'entrée référence de l'unité de détection corrective 16.

La cellule de sélection finale 19 peut, par exemple, être décrite comme composée d'une porte 'ET' à deux entrées. Sur les entrées de la porte sont envoyés respectivement le signal $S_{DRP}$ et le signal $S_{RS1}$ sortant du circuit de génération des signaux de sélection 22. Cette porte génère en sortie un signal $S_{DRF}$ qui est envoyé sur l'entrée diviseur du comparateur de phase 20 de l'unité de déphasage 13.

Avantageusement, dans ce cas où tous les déphasages $\Phi_{var\ e}$ des cellules élémentaires à retard variable 14 de l'unité de déphasage 13 sont identiques, le système électronique selon la figure 1 permet d'aligner les fronts actifs $F_{Dmk+2}$ des signaux $S_{DRk+1}$ avec les fronts actifs $F_{Rmk+2}$, avec $1 \leq k \leq P - 2$, $k \in \mathbb{N}$, en moyenne dans le temps. Cela permet alors de détecter et corriger les variations de la phase liées au bruit de phase de la boucle à verrouillage de phase PLL.

Dans d'autres modes de réalisation, la cellule de déphasage initial variable 8 peut être omise si la largeur d'impulsion du signal en sortie du comparateur de phase/fréquence 2 est en moyenne dans le temps nulle. C'est-à-dire si aucun courant de fuite dans le filtre 3 ou un varactor de l'oscillateur variable commandé en tension 4 n'induit une variation de la tension de contrôle de l'oscillateur variable commandé en tension 4, nécessitant une correction périodique de cette tension.

Selon la figure 1, lors du calcul de la bande passante de la boucle à verrouillage de phase PLL, le filtre de boucle de correction du bruit 17 est pris en compte dans le dimensionnement du filtre 3 de la boucle à verrouillage de phase PLL.

De même, lors du calcul de la bande passante de la boucle de correction du bruit, le filtre 3 de la boucle à verrouillage de phase PLL est pris en compte dans le dimensionnement du filtre de boucle de correction du bruit 17.

Cette configuration permet, avantageusement, de dissocier le choix de la bande passante de la boucle à verrouillage de phase PLL qui peut être définie en fonction de la réponse dynamique souhaitée de la boucle à verrouillage de phase PLL, de celui de la bande passante du système de correction de bruit, ce qui permet de corriger le bruit de phase sur une bande de fréquence plus large.

Avantageusement encore, afin d'éviter que des raies parasites n'apparaissent sur le spectre de sortie du signal $S_S$ à la fréquence de comparaison $F_C$, le comparateur de phase 16 peut ne fonctionner qu'un front actif du signal de référence $S_R$ sur deux.

Dans ce mode de réalisation, la boucle à verrouillage de phase PLL a un fonctionnement nominal, la correction du bruit s'effectue lorsqu'elle est naturellement ouverte.

S'il existe une dispersion des retard $\Phi_{var\ e}$, cela se traduit par des impulsions générées par les P-2 cellules élémentaires à retard variable 14 de largeurs différentes et donc par une injection de courant moyen non nul pendant une période de comparaison. Cette valeur moyenne est compensée par la variation de la largeur $T_{er}$ de l'impulsion du signal $S_{PFDp}$ générée par le comparateur de phase/fréquence 2.

Pendant la phase transitoire de verrouillage de la boucle à verrouillage de phase PLL, tous les signaux de sélection $S_{RSk}$ sont inactifs : le système de correction du bruit est alors ouvert.

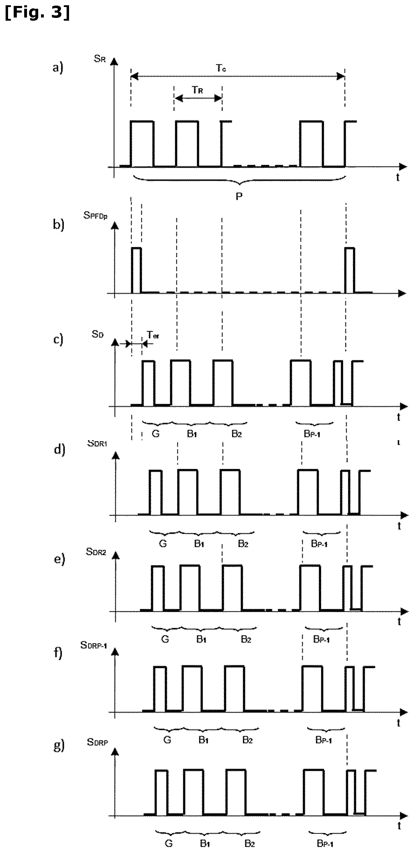

Les figures 3a à 3g) représentent le signal de référence, le signal d'erreur et un déphasage des trames des signaux de détection de bruit selon un mode de réalisation de l'invention.

La figure 3a) représente le signal de référence $S_R$ en fonction du temps. La période de comparaison comprend P coups d'horloge.

La figure 3b) représente le signal $S_{PFDp}$ en sortie du comparateur de phase/fréquence 2 en fonction du temps. Le comparateur de phase/fréquence 2 détecte le retard entre le front actif $F_{DD}$ du signal $S_{DD}$ qui est synchrone du front actif $F_{Dm1}$ du signal $S_D$ et le front actif $F_{cm}$ du signal de comparaison $S_c$. Le signal $S_{PFDp}$ génère une impulsion de largeur $T_{er}$ non nulle (voir figure 3c).

La figure 3c) représente le signal $S_D$ en sortie du compteur générateur de trame 7 en fonction du temps. Le front actif $F_{Dm1}$ du signal $S_D$ est synchronisé par rapport au retard *Ter.*

La figure 3d) représente le signal $S_{DR1}$ en sortie de la cellule de déphasage initial variable 8. Le signal $S_{DR1}$ correspond au signal $S_D$ déphasé d'une valeur : $\Phi_{var\,i}$. En effet, la cellule de déphasage initial variable 8 génère un retard $\Phi_{vari}$ permettant de synchroniser le front actif $F_{Dm2}$ du premier bloc principal ($B_1$) du signal $S_{DR1}$ avec le front actif $F_{Rm2}$ du signal $S_R$. La synchronisation de ces deux derniers fronts déterminant le critère permettant de définir la valeur de $\Phi_{var\,i}$.

Les figures 3e) et 3f) représentent les signaux $S_{DR2}$ et $S_{DRP\text{-}1}$ correspondant aux signaux de sortie des deux cellules à retard distinct variable 14.

Chaque cellule élémentaire à retard distinct variable 14 permet d'introduire un retard $\Phi_{var\,e}$ identique entre les signaux $S_{DRk}$ et $S_{DRk+1}$ avec $1 \le k \le P - 2$, $k \in \mathbb{N}$, afin d'aligner les fronts actifs $F_{Dmk+2}$ des signaux $S_{DRk+1}$ et les fronts actifs $F_{Rmk+2}$ du signal de référence $S_R$. Par conséquent, sur la figure 3e), le front actif $F_{Dm3}$ du signal $S_{DR2}$ est synchronisé avec le front actif $F_{Rm3}$ du signal de référence $S_R$. Sur la figure 3f), le front actif $F_{DmP}$ du signal $S_{DRP\text{-}1}$ est synchronisé avec le front actif $F_{Rmp}$ du signal de référence $S_R$.

La figure 3f) représente le signal $S_{DRP}$ en sortie de la cellule de déphasage final variable 18. La cellule de déphasage final variable 18 permet d'introduire un retard $\Phi_{var\,e}$ entre les signaux $S_{DRP\text{-}1}$ et $S_{DRP}$ afin d'aligner le front actif $F_{DmP+1}$ du signal $S_{DRP}$ et le front actif $F_{cm}$ de la période de comparaison suivante.

La synchronisation de ces deux derniers fronts détermine le critère permettant de définir la valeur de $\Phi_{var\,e}$.

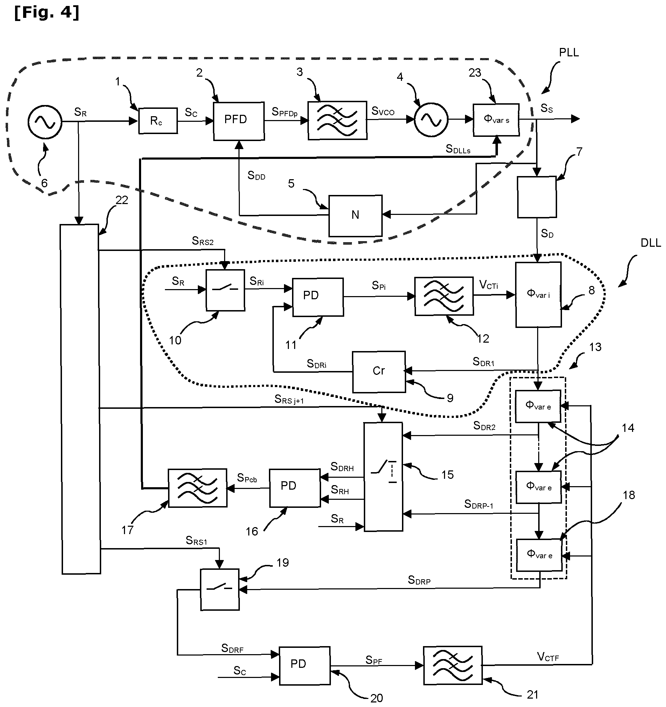

La figure 4 représente un système électronique selon un second mode de réalisation de l'invention.

Le système électronique de la figure 4 est identique au système électronique décrit dans la figure 1 à la différence que la boucle à verrouillage de phase PLL comprend, en outre, une cellule à retard variable 23 en sortie de l'oscillateur commandé en tension 4, dont la grandeur de contrôle $S_{DLLs}$ correspond au signal généré en sortie du filtre de boucle de correction du bruit 17. En effet, la correction de bruit de phase, en sortie du filtre de boucle de correction de bruit 17, est appliquée sur une entrée de contrôle de la cellule à retard variable 23.

Bien entendu l'invention n'est pas limitée aux exemples qui viennent d'être décrits.

### Références

[1] Behzad Razavi, "Design of CMOS Phase-Locked Loops, From Circuit Level to Architecture Level" Cambridge University press, 2020.
[2] M.H. Perrott, "Fast and Accurate Behavioral Simulation of Fractional-N Synthesizers and other PLL/DLL Circuits", Design Automation Conference (DAC), 2002, pp 498-503.
[3] Floyd M. Gardner, "Phaselock Techniques," 3rd ed., New Jersey: Wiley, 2005.
[4] I. Galton, "Delta-Sigma Fractional-N Phase-Locked Loops", Phase-Locking in High-Performance Systems: From Devices to Architectures (ed. Behzad Razavi), Wiley-IEEE Press, 2003.
[5] Donhee Ham, William Andress, David Ricketts "Phase Noise in Oscillators" Harvard University, Cambridge, MA 02138, USA, 2004.

### Revendications

1. Système de correction de bruit de phase d'une boucle à verrouillage de phase (PLL), la boucle à verrouillage de phase (PLL) comprenant un signal de référence ($S_R$), le système de correction de bruit de phase comprenant au moins :

   - un compteur générateur de trame (7) recevant en entrée un signal de sortie ($S_S$) de la boucle à verrouillage de phase (PLL) et étant configuré pour générer, en sortie, au moins un signal ($S_D$) de détection de bruit défini sous la forme d'une trame, la trame étant composée de plusieurs blocs définis temporellement, chaque bloc définissant un front actif ;
   - une unité de déphasage (13) configurée pour générer au moins un signal de détection de bruit retardé, chaque signal de détection de bruit retardé comprenant un retard distinct, l'unité de déphasage étant configurée pour synchroniser au moins un front actif de l'au moins un signal ($S_{DRk+1}$) de détection de bruit retardé avec au moins un front actif du signal de référence ($S_R$), chaque retard distinct étant défini de façon à ce qu'une moyenne des écarts instantanés entre un front actif de l'au moins un signal ($S_{DRk+1}$) de détection de bruit retardé et un front actif du signal de référence ($S_R$) converge vers zéro ;
   - une unité de détection corrective (16) configurée pour :

      • calculer une erreur de phase instantanée sur la base d'une comparaison entre un front actif de l'au moins un signal ($S_{DRk+1}$) de détection de bruit retardé et un front actif du signal de référence ($S_R$),
      • générer des impulsions en fonction de l'erreur de phase instantanée de façon à corriger un bruit de phase de la boucle à verrouillage de phase (PLL).

2. Système de correction de bruit de phase selon la revendication 1, dans lequel, le système comprend, en outre, un filtre de boucle de correction de bruit (17), le filtre de boucle de correction de bruit (17) étant connecté à une sortie de l'unité de détection corrective (16).

3. Système de correction de bruit de phase selon les revendications 1 à 2, dans lequel la boucle à verrouillage de phase (PLL) comprend au moins un oscillateur variable commandé en tension (4), la correction de bruit de phase étant appliquée à au moins une entrée de l'oscillateur commandé en tension (4).

4. Système de correction de bruit de phase selon les revendications 1 à 2, dans lequel la boucle à verrouillage de phase (PLL) comprend au moins une cellule à retard variable (23), la correction de bruit de phase étant appliquée sur une entrée de contrôle de l'au moins une cellule à retard variable (23).

5. Système de correction de bruit de phase selon l'une quelconque des revendications précédentes, comprenant, en outre, une boucle de retard initiale (DLL), recevant en entrée, l'au moins un signal ($S_D$) de détection de bruit généré par le compteur générateur de trame (7) et étant configurée pour générer en sortie, pour chaque signal ($S_D$) de détection de bruit, au moins un signal de détection de bruit différé ($S_{DR1}$) de façon à ce qu'au moins un front actif du signal de détection de bruit différé soit synchronisé avec au moins un front actif du signal de référence ($S_R$).

6. Système de correction de bruit de phase selon l'une quelconque des revendications précédentes, dans lequel l'unité de déphasage (13) comprend au moins une chaine de déphasage variable et une cellule de déphasage final variable (18).

7. Système de correction de bruit de phase selon la revendication 6, dans lequel l'au moins une chaine de déphasage variable comprend des cellules élémentaires à retard variable (14) placées en série, les cellules élémentaires à retard variable (14) ayant un déphasage $\Phi_{var\ e}$ identique.

8. Système de correction de bruit de phase selon l'une quelconque des revendications précédentes, dans lequel la longueur de la trame du signal de détection de bruit retardé est inférieure ou égale à un multiple entier d'une période d'un signal de comparaison ($S_C$).

9. Système de correction de bruit de phase selon l'une quelconque des revendications précédentes, dans lequel l'unité de détection corrective (16) est configurée pour comparer un front actif du signal de référence ($S_R$) sur deux avec un front actif de l'au moins un signal de détection de bruit retardé.

10. Procédé de correction de bruit de phase d'une boucle à verrouillage de phase (PLL), la boucle à verrouillage de phase (PLL) comprenant un signal de référence ($S_R$), le procédé étant mis en oeuvre par ordinateur et comprenant les étapes suivantes :

- générer au moins un signal ($S_D$) de détection de bruit défini sous la forme d'une trame à partir d'un signal ($S_S$) de sortie de la boucle à verrouillage de phase (PLL), la trame étant composée de plusieurs blocs définis temporellement, chaque bloc définissant un front actif ;
- générer au moins un signal ($S_{DRk+1}$) de détection de bruit retardé, chaque signal ($S_{DRk+1}$) de détection de bruit retardé comprenant un retard distinct,
- synchroniser au moins un front actif de l'au moins un signal ($S_{DRk+1}$) de détection de bruit retardé avec au moins un front actif du signal de référence ($S_R$), chaque retard distinct étant défini de façon qu'une moyenne des écarts instantanés entre un front actif de l'au moins un signal ($S_{DRk+1}$) de détection de bruit retardé et un front actif du signal de référence ($S_R$) converge vers zéro ;
- calculer une erreur de phase instantanée sur la base d'une comparaison entre un front actif de l'au moins un signal ($S_{DRk+1}$) de détection de bruit retardé et un front actif du signal de référence ($S_R$),
- générer des impulsions en fonction de l'erreur de phase instantanée de façon à corriger un bruit de phase de la boucle à verrouillage de phase (PLL).

**Revendications modifiées conformément à la règle 137(2) CBE.**

1. Système de correction de bruit de phase d'une boucle à verrouillage de phase (PLL), la boucle à verrouillage de phase (PLL) utilisant comme référence un signal de comparaison ($S_C$) ayant une période de comparaison ($T_C$), le signal de comparaison ($S_C$) étant obtenu en divisant la fréquence d'un signal de référence ($S_R$), le système de correction de bruit de phase comprenant au moins :

- un compteur générateur de trame (7) recevant en entrée un signal de sortie ($S_S$) de la boucle à verrouillage de phase (PLL) et étant configuré pour générer, en sortie, au moins un signal ($S_D$) de détection de bruit défini sous la forme d'une trame, la trame étant composée de plusieurs blocs définis temporellement, chaque bloc définissant un front actif ;
- une unité de déphasage (13) configurée pour recevoir en entrée l'au moins un signal ($S_D$) de détection de bruit , et générer, pour chaque signal ($S_D$) de détection de bruit, au moins un signal de détection de bruit retardé, chaque signal de détection de bruit retardé comprenant un retard distinct, l'unité de déphasage étant configurée pour synchroniser au moins un front actif de l'au moins un signal ($S_{DRk+1}$) de détection de bruit retardé avec au moins un front actif du signal de référence ($S_R$), chaque retard distinct étant défini de façon à ce qu'une moyenne des écarts instantanés entre un front actif de l'au moins un signal ($S_{DRk+1}$) de détection de bruit retardé et un front actif du signal de référence ($S_R$) converge vers zéro ;

- une unité de détection corrective (16) configurée pour :

> • calculer une erreur de phase instantanée sur la base d'une comparaison entre un front actif de l'au moins un signal ($S_{DRk+1}$) de détection de bruit retardé et un front actif du signal de référence ($S_R$),
> • générer des impulsions en fonction de l'erreur de phase instantanée de façon à corriger un bruit de phase de la boucle à verrouillage de phase (PLL),

les impulsions générées étant configurées pour modifier une valeur de grandeur de contrôle d'un oscillateur et/ou
les impulsions générées étant configurées pour modifier une valeur de grandeur d'au moins une cellule à retard variable.

2. Système de correction de bruit de phase selon la revendication 1, dans lequel, le système comprend, en outre, un filtre de boucle de correction de bruit (17), le filtre de boucle de correction de bruit (17) étant connecté à une sortie de l'unité de détection corrective (16).

3. Système de correction de bruit de phase selon les revendications 1 à 2, dans lequel la boucle à verrouillage de phase (PLL) comprend au moins un oscillateur variable commandé en tension (4), la correction de bruit de phase étant appliquée à au moins une entrée de l'oscillateur commandé en tension (4).

4. Système de correction de bruit de phase selon les revendications 1 à 3, dans lequel la boucle à verrouillage de phase (PLL) comprend au moins une cellule à retard variable (23) en sortie de l'oscillateur commandé en tension, la correction de bruit de phase étant appliquée sur une entrée de contrôle de l'au moins une cellule à retard variable (23).

5. Système de correction de bruit de phase selon l'une quelconque des revendications précédentes, comprenant, en outre, une boucle de retard initial (DLL), recevant en entrée, l'au moins un signal ($S_D$) de détection de bruit généré par le compteur générateur de trame (7) et étant configurée pour générer en sortie, pour chaque signal ($S_D$) de détection de bruit, au moins un signal de détection de bruit différé ($S_{DR1}$) de façon à ce qu'au moins un front actif du signal de détection de bruit différé soit synchronisé avec au moins un front actif du signal de référence ($S_R$), l'unité de déphasage (13) étant configurée pour recevoir en entrée l'au moins un signal de détection de bruit différé ($S_{DR1}$) au lieu du au moins un signal ($S_D$) de détection de bruit afin de générer l'au moins un signal de détection de bruit retardé .

6. Système de correction de bruit de phase selon l'une quelconque des revendications précédentes, dans lequel l'unité de déphasage (13) comprend au moins une chaine de déphasage variable et une cellule de déphasage final variable (18).

7. Système de correction de bruit de phase selon la revendication 6, dans lequel l'au moins une chaine de déphasage variable comprend des cellules élémentaires à retard variable (14) placées en série, les cellules élémentaires à retard variable (14) ayant un déphasage $\Phi_{var\ e}$ identique.

8. Système de correction de bruit de phase selon l'une quelconque des revendications précédentes, dans lequel la longueur de la trame du signal de détection de bruit retardé est inférieure ou égale à un multiple entier d'une période d'un signal de comparaison ($S_C$).

9. Système de correction de bruit de phase selon l'une quelconque des revendications précédentes, dans lequel l'unité de détection corrective (16) est configurée pour comparer un front actif du signal de référence ($S_R$) sur deux avec un front actif de l'au moins un signal de détection de bruit retardé.

10. Procédé de correction de bruit de phase d'une boucle à verrouillage de phase (PLL), la boucle à verrouillage de phase (PLL) utilisant comme référence un signal de comparaison ($S_C$) ayant une période de comparaison ($T_C$) , le signal de comparaison ($S_C$) étant obtenu en divisant la fréquence d'un signal de référence($S_R$), le procédé étant mis en œuvre par ordinateur et comprenant les étapes suivantes :

> - Générer au moins un signal ($S_D$) de détection de bruit défini sous la forme d'une trame à partir d'un signal ($S_S$) de sortie de la boucle à verrouillage de phase (PLL), la trame étant composée de plusieurs blocs définis temporellement, chaque bloc définissant un front actif ;
> - recevoir l'au moins un signal ($S_D$) de détection de bruit, et générer , pour chaque signal ($S_D$) de détection de bruit, au moins un signal ($S_{DRk+1}$) de détection de bruit retardé, chaque signal ($S_{DRk+1}$) de détection de bruit retardé comprenant un retard distinct,

- synchroniser au moins un front actif de l'au moins un signal ($S_{DRk+1}$) de détection de bruit retardé avec au moins un front actif du signal de référence ($S_R$), chaque retard distinct étant défini de façon qu'une moyenne des écarts instantanés entre un front actif de l'au moins un signal ($S_{DRk+1}$) de détection de bruit retardé et un front actif du signal de référence ($S_R$) converge vers zéro ;

- calculer une erreur de phase instantanée sur la base d'une comparaison entre un front actif de l'au moins un signal ($S_{DRk+1}$) de détection de bruit retardé et un front actif du signal de référence ($S_R$),

- générer des impulsions en fonction de l'erreur de phase instantanée de façon à corriger un bruit de phase de la boucle à verrouillage de phase (PLL),

les impulsions générées étant configurées pour modifier une valeur de grandeur de contrôle d'un oscillateur et/ou les impulsions générées étant configurées pour modifier une valeur de grandeur d'au moins une cellule à retard variable.

**[Fig. 1]**

[Fig. 2]

**[Fig. 3]**

[Fig. 4]

| | Europäisches Patentamt European Patent Office Office européen des brevets | **RAPPORT DE RECHERCHE EUROPEENNE** | **Numéro de la demande** EP 24 30 6636 |
|---|---|---|---|

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2004/027181 A1 (WATANABE HIDEAKI [JP]) 12 février 2004 (2004-02-12) * alinéa [0001] - alinéa [0054]; figures 1-7 * ----- | 1-10 | INV. H03L7/087 H03L7/081 H03L7/10 |
| A | US 5 828 255 A (KELKAR RAM [US] ET AL) 27 octobre 1998 (1998-10-27) * colonne 1 - colonne 6; figures 1-9 * ----- | 1-10 | |
| A | EP 0 889 411 B1 (SUN MICROSYSTEMS INC [US]) 4 juin 2003 (2003-06-04) * alinéa [0001] - alinéa [0038]; figures 1-3B * ----- | 1-10 | |
| A | US 2015/015313 A1 (WALTARI MIKKO [US] ET AL) 15 janvier 2015 (2015-01-15) * alinéa [0001] - alinéa [0080]; figures 1-19B * ----- | 1-10 | |
| A | US 2012/074997 A1 (KIM KI-JIN [KR] ET AL) 29 mars 2012 (2012-03-29) * alinéa [0001] - alinéa [0080]; figures 1-9 * ----- | 1-10 | **DOMAINES TECHNIQUES RECHERCHES (IPC)** H03L |

Le présent rapport a été établi pour toutes les revendications

| Lieu de la recherche | Date d'achèvement de la recherche | Examinateur |
|---|---|---|
| La Haye | 18 mars 2025 | Rafflenbeul, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 30 6636

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-03-2025

| Document brevet cité au rapport de recherche | Date de publication | Membre(s) de la famille de brevet(s) | | Date de publication |
|---|---|---|---|---|
| US 2004027181 A1 | 12-02-2004 | JP | 2004032586 A | 29-01-2004 |
| | | US | 2004027181 A1 | 12-02-2004 |
| US 5828255 A | 27-10-1998 | AUCUN | | |
| EP 0889411 B1 | 04-06-2003 | EP | 0889411 A2 | 07-01-1999 |
| | | US | 5889435 A | 30-03-1999 |
| US 2015015313 A1 | 15-01-2015 | US | 8917124 B1 | 23-12-2014 |
| | | US | 9007108 B1 | 14-04-2015 |
| | | US | 2014070859 A1 | 13-03-2014 |
| | | US | 2015022384 A1 | 22-01-2015 |
| US 2012074997 A1 | 29-03-2012 | KR | 20120032951 A | 06-04-2012 |
| | | US | 2012074997 A1 | 29-03-2012 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **BEHZAD RAZAVI**. Design of CMOS Phase-Locked Loops, From Circuit Level to Architecture Level. Cambridge University press, 2020
- **M.H. PERROTT**. Fast and Accurate Behavioral Simulation of Fractional-N Synthesizers and other PLL/DLL Circuits. *Design Automation Conference (DAC)*, 2002, 498-503
- **FLOYD M. GARDNER**. Phaselock Techniques. Wiley, 2005
- **I. GALTON**. Delta-Sigma Fractional-N Phase-Locked Loops'', Phase-Locking in High-Performance Systems: From Devices to Architectures. Wiley-IEEE Press, 2003
- **DONHEE HAM** ; **WILLIAM ANDRESS** ; **DAVID RICKETTS**. Phase Noise in Oscillators. Harvard University, 2004